# FASCICULE DE BREVET EUROPEEN

(11) **EP 0 747 160 B1**
(45) Date de publication et mention de la délivrance du brevet: **28.07.1999**
(21) Numéro de dépôt: 96401173.8
(22) Date de dépôt: 31.05.1996
(51) Int. Cl.: B23K 1/20

(54) **Procédé et dispositif de brasage à la vague intégrant une opération de fluxage par voie sèche**
Verfahren und Vorrichtung zum Wellenlöten mit integriertem Trockenflussverfahren
Process and device for wave soldering integrating a dry reflow operation

(30) Priorité: 09.06.1995 FR 9506818
(43) Date de publication de la demande: 11.12.1996
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Sindzingre, Thierry, 94230 Cachan (FR); Rabia, Stéphane, 14 Parc du Château de Courcelles, 91190 Gif sur Yvette (FR); Potier, Nicolas, 75015 Paris (FR)
(74) Mandataire: Vesin, Jacques

(56) Documents cités:
- EP-A- 0 427 020
- EP-A- 0 658 391
- FR-A- 2 683 114
- FR-A- 2 692 730

## Description

La présente invention concerne les opérations de brasage à la vague en électronique. Elle s'applique ainsi notamment aux opérations :
- de brasage à la vague de composants sur circuit (qu'il s'agisse de composants insérés ou de composants montés en surface),
- de brasage à la vague de bandes de contacts sur supports électroniques, permettant la connexion du support en question sur un autre support (on peut considérer ici l'exemple d'un circuit hybride ou d'un circuit imprimé que l'on va insérer grâce à ces contacts dans un circuit imprimé, ou encore un circuit hybride ou imprimé que l'on va pouvoir enficher, grâce à ce peigne, dans un connecteur).

Le rôle du fluxage est alors de préparer les surfaces métalliques à braser (réalisant des actions telles que dégraissage, désoxydation, décontamination de couches adsorbées, ou autre préparation de surface), ceci dans le but de faciliter le mouillage ultérieur de ces surfaces par la soudure, mais également d'éliminer les oxydes qui pourraient se former en température au niveau de l'alliage de brasure.

Cette opération de fluxage est, le plus couramment, pratiquée à l'aide de flux chimiques, souvent obtenus à partir de bases résineuses, complétées notamment par des composés acides. Après brasage, demeurent sur la pièce des résidus de flux, obligeant souvent le fabricant à effectuer une opération de nettoyage, le plus souvent avec des solvants chlorés, opération de nettoyage qui s'avère très controversée, dans le contexte du "Protocole de Montréal" et de ses révisions ultérieures où ces solvants font l'objet d'une réglementation très stricte, voir pour certains, selon les pays, d'une interdiction pure et simple.

La conception des machines de brasage à la vague est telle que les pièces à braser sont amenées en contact avec une ou plusieurs vagues de soudure liquide obtenues par circulation du bain de soudure contenu dans un bac, au travers d'une ou plusieurs buses.

Au préalable, les pièces (par exemple les circuits sur lesquels ont été reportés des composants), ont généralement été fluxées dans une zone amont de la machine, à l'aide d'un spray de flux ou d'une mousse de flux ("foam"), l'opération de fluxage étant généralement suivie d'une opération de préchauffage qui est pratiquée pour activer les flux précédemment déposés sur le circuit et pour préchauffer les circuits avant leur arrivée dans la zone chaude de brasage. Un système de convoyage est présent pour déplacer les pièces d'une zone à l'autre de la machine.

Le problème du nettoyage des objets après brasage a été à l'origine de nombreux efforts de recherche dans le monde ces dernières années pour essayer de proposer une solution de remplacement à l'utilisation de ces composés.

Parmi les solutions envisagées, on peut citer des procédé de fluxage par voie sèche tel que le fluxage plasma des surfaces avant brasage, évitant de ce fait l'utilisation de flux chimiques et donc la nécessité même d'une opération de nettoyage en aval. Les mélanges envisagés mettent notamment en oeuvre de l'hydrogène.

On peut citer dans ce domaine le document EP-A-0427020, qui propose d'effectuer un traitement des pièces d'assemblage à braser à l'aide d'un plasma d'un gaz de procédé, en recommandant l'utilisation de basses pressions pour ce traitement, "dans le but d'éviter un endommagement thermique des pièces d'assemblage". Tous les exemples donnés, en relation avec les figures fournies, concernent des conditions de pression situées dans l'intervalle 30-100 Pa.

La même remarque peut être effectuée à propos du document EP-A-0371693 qui concerne un procédé de fluxage de surfaces métalliques avant brasage, par plasma micro-ondes contenant de l'hydrogène. Ici encore, il est recommandé d'utiliser des basses pressions "pour permettre de limiter le niveau d'oxygène résiduel dans le plasma".

Cette unanimité dans l'utilisation de conditions de basses pressions pour réaliser ces fluxages plasma, malgré les inconvénients liés notamment au coût d'obtention de telles pressions ou encore à la difficulté d'implantation des infrastructures correspondantes dans une chaîne de production, est sans aucun doute liée à la difficulté technique et technologique d'obtention de plasmas à pression atmosphérique donnant des performances comparables à ce qui est traditionnellement obtenu à basse pression.

Dans ce contexte, la demanderesse, avait, dans le document FR-A-2,697,456, proposé un procédé de fluxage plasma de surfaces métalliques avant brasage, à la pression atmosphérique, utilisant pour créer le plasma une source de micro-ondes ou encore une décharge à barrière diélectrique transférée via des lumières placées de façon adéquate dans une couche diélectrique placée au dessus de la pièce à traiter. Si ce document apporte une réponse intéressante au problème considéré, la Demanderesse a mis en évidence le fait que le procédé proposé pourrait être amélioré, notamment en ce qui concerne :
- son rendement (rapport de la puissance introduite pour créer le plasma à la densité d'espèces produites qui interagissent effectivement avec le support à traiter), ou encore la densité d'énergie admissible (dans le cas de la décharge à barrière diélectrique, elle n'atteint que W par cm² de diélectrique), qui si ils étaient accrus pourraient permettre des temps de traitement plus courts,
- mais aussi du fait de facteurs "géométriques" limitants : dans le cas de la décharge couronne, la distance électrode/échantillon est tout à fait critique et doit être maintenue très faible, ce qui peut poser problème dans le cas de substrats dont le relief est relativement tourmenté; dans le cas de la décharge micro-ondes, elle donne lieu à la formation d'un spot plasmagène, de dimensions déterminées et limitées par la source plasma,
- par ailleurs, un plasma tel que celui créé dans ce document, contient par définition des espèces ioniques et des électrons (donc des espèces électriquement chargées) dont l'emploi est toujours délicat sur des composants électroniques.

En poursuivant ses travaux sur ce sujet, la Demanderesse a alors plus récemment proposé, dans le document EP-A-0 658 391 qui est compris dans l'état de la technique au sens de l'àrticle 54.3 CBE un procédé amélioré de fluxage par voie sèche d'une surface métallique avant brasage ou étamage à l'aide d'un alliage, remarquable en ce qu'il met en oeuvre les étapes suivantes :
a) on fait passer un mélange gazeux initial comprenant un gaz inerte et/ou un gaz réducteur et/ou un gaz oxydant, dans au moins un appareil de formation d'espèces gazeuses excitées ou instables, pour obtenir en sortie d'appareil, un mélange gazeux primaire;
b) on traite la surface à fluxer, à une pression voisine de la pression atmosphérique, par une atmosphère gazeuse de traitement comprenant des espèces excitées ou instables et substantiellement dépourvue d'espèces électriquement chargées, obtenue à partir du mélange gazeux primaire considéré.

Les exemples développés dans ce document démontraient clairement qu'il est possible, par ce procédé, notamment :
- d'opérer sensiblement à pression atmosphérique,
- d'obtenir une grande flexibilité de distance entre l'objet à traiter et le dispositif utilisé pour effectuer ce traitement,
- d'éviter le contact des pièces avec des espèces chargées,
- d'offrir une densité énergétique améliorée, permettant d'atteindre une vitesse de traitement accrue.

L'atmosphère de traitement qui est obtenue à partir du mélange gazeux primaire, lui même obtenu à la sortie de gaz d'un appareil de formation d'espèces gazeuses excitées ou instables, peut d'ailleurs selon ce document également comprendre le cas échéant un mélange gazeux adjacent n'ayant pas transité par l'appareil.

On peut donc qualifier cette configuration de "post-décharge" puisque la composante primaire de l'atmosphère de traitement, qui comprend des espèces gazeuses excitées ou instables, est obtenue en sortie d'appareil, ce qui assure l'absence substantielle de toute espèce électriquement chargée dans cette composante primaire. La composante adjacente de l'atmosphère de traitement, qui n'a pas transité par l'appareil, en est à fortiori dépourvue.

Par ailleurs, cette configuration permet de nettement séparer le lieu de la génération de la composante primaire de l'atmosphère du lieu de son utilisation, ce qui présente un avantage non négligeable en terme de pollution de l'appareil (éviter que les dégagements divers résultant de l'opération de fluxage de la surface n'aillent polluer l'intérieur de l'appareil, par exemple ses électrodes), mais également de reproductibilité de l'atmosphère rencontrée par la pièce.

Enfin, la pièce, qui n'est pas traitée au sein de l'appareil (par exemple au sein de la décharge entre les électrodes), bénéficie d'une bien meilleure flexibilité sur l'aspect "distance" évoqué plus haut.

Ce procédé était, dans ce document, tout particulièrement exemplifié et illustré à l'aide d'un dispositif particulier de formation de molécules gazeuses excitées ou instables, fonctionnant sensiblement à la pression atmosphérique, que la Demanderesse avait précédemment développé et qui est décrit dans le document FR-A-2,692,730.

La Demanderesse a depuis poursuivi ses travaux sur ce sujet, en vu d'améliorer encore le procédé de fluxage par voie sèche d'une surface métallique avant brasage ou étamage selon le document EP-A-0 658 391, et en particulier son adaptation au cas spécifique du brasage à la vague où doivent parfois être brasés des circuits double face, équipés de composants électroniques du type "montés en surface" et du type "insérés à fil". Ces travaux ont permis de démontrer qu'en l'absence de fluxage chimique, remplacé par un fluxage par voie sèche, le brasage des composants à fil posait des difficultés importantes, donnant lieu en l'occurrence à l'observation de défauts de remontée de la brasure dans les trous métallisés.

Ces travaux ont permis de démontrer, que dans ce cas du brasage à la vague, il était tout particulièrement avantageux de mettre en contact, en amont du bain de soudure, chaque face du circuit avec le mélange gazeux primaire obtenu à la sortie de gaz d'au moins un appareil de formation de molécules gazeuses excitées ou instables, la face supérieure du circuit étant préférentiellement mise en contact avec les sorties de gaz d'au moins deux appareils de formation de molécules gazeuses excitées ou instables disposés en série.

Le procédé de brasage à la vague d'un circuit, selon la présente invention, au cours duquel, on met en contact le circuit avec au moins une vague d'alliage de soudure liquide, obtenue par pompage d'un bain liquide de l'alliage contenu dans un bac, au travers d'une buse, se caractérise en ce que, préalablement à cette mise en contact, chacune des faces du circuit a été, à une pression voisine de la pression atmosphérique, amenée en regard de la sortie de gaz d'au moins un appareil de formation d'espèces gazeuses excitées ou instables dans lequel on fait passer un mélange gazeux initial comprenant un gaz inerte et/ou un gaz réducteur et/ou un gaz oxydant, pour obtenir, après transformation, en sortie de gaz de l'appareil, un mélange gazeux primaire comprenant des espèces gazeuses excitées ou instables et substantiellement dépourvu d'espèces électriquement chargées.

Avantageusement, la face supérieure du circuit est successivement amenée en regard des sorties de gaz d'au moins deux appareils de formation d'espèces gazeuses excitées ou instables disposés en série.

Le "circuit" selon l'invention pourra consister en tout assemblage pouvant intervenir dans de telles opérations de brasage, qu'il s'agisse par exemple d'un circuit électronique sur lequel on a reporté des composants en vu de les braser (qu'il s'agisse de composants insérés ou de composants montés en surface), ou bien encore d'un couple bande de contacts/support électronique (brasage de la bande sur le support).

L"'alliage" selon l'invention sera constitué par toute composition que l'on peut envisager pour une telle opération telle que par exemple Sn-Pb, Sn-Pb-Ag etc..

On entend par l'expression "pression voisine de la pression atmosphérique" selon l'invention, une pression se situant avantageusement dans l'intervalle [0,1 x 10⁵ Pa, 3 x 10⁵ Pa], donc entre environ 0,1 et 3 bar.

On entend par l'expression "espèces électriquement chargées" selon l'invention, des ions ou des électrons. L'atmosphère de traitement que rencontre le circuit, obtenue à partir du mélange primaire, se distingue donc des atmosphères plasma utilisées dans la littérature antérieure par le fait qu'elle est substantiellement dépourvue d'espèces électriquement chargées, c'est à dire d'ions où d'électrons.

L'atmosphère de traitement du circuit, qui est obtenue à partir du mélange gazeux primaire, peut également comprendre le cas échéant un mélange gazeux adjacent, le mélange gazeux primaire étant obtenu à la sortie de gaz de l'appareil de formation d'espèces gazeuses excitées ou instables dans lequel a été transformé le mélange gazeux initial tandis que le mélange gazeux adjacent n'a lui pas transité par l'appareil.

Comme précédemment développé dans le paragraphe consacré au document EP-A-0 658 391, on peut qualifier cette configuration de "post-décharge" avec tous les avantages qui en découlent et qui ont déjà été énumérés.

Le gaz inerte peut par exemple consister en de l'azote, de l'argon, de l'hélium ou un mélange de tels gaz inertes. Le gaz réducteur peut par exemple consister en de l'hydrogène, du CH₄ ou encore de l'ammoniac ou un mélange de tels gaz réducteurs. Le gaz oxydant peut quant à lui par exemple consister en de l'oxygène, ou du CO₂, ou encore du N₂O, H₂O, ou un mélange de tels gaz oxydants. La liste de gaz donnés dans chaque catégorie n'étant bien entendu qu'indicative, nullement limitative.

L'appareil selon l'invention est constitué par tout dispositif permettant "d'exciter" un mélange gazeux initial, pour obtenir, en sortie de gaz de l'appareil, un autre mélange gazeux (que l'on qualifie ici de primaire) comportant des espèces gazeuses instables ou excitées, ce dernier mélange gazeux étant substantiellement dépourvu d'espèces électriquement chargées. Un telle excitation pourra par exemple être obtenue par une décharge électrique, par exemple du type décharge couronne.

Le document FR-A-2,692,730 au nom de la Demanderesse précédemment évoqué décrit un appareil de formation de molécules gazeuses excitées ou instables convenant pour la mise en oeuvre du procédé selon la présente invention.

Le mélange adjacent, selon l'invention, pourra être constitué de tout gaz ou mélange de gaz, par exemple d'un gaz inerte ou mélange de gaz inertes permettant de maintenir, le cas échéant, une atmosphère protectrice autour des échantillons, ou encore d'un gaz réducteur ou d'un gaz oxydant, voire d'un mélange de gaz appartenant à l'une de ces trois catégories.

Selon un des aspects de l'invention, le mélange adjacent contient du silane SiH₄. La présence d'un tel mélange adjacent contenant du silane est avantageusement utilisée pour son action réductrice vis-à-vis de certains oxydes métalliques présents à la surface de la pièce à traiter, mais aussi, selon le mélange gazeux initial utilisé, comme "guetter" (ou piègeur) d'oxygène, c'est-à-dire dans son interaction avec l'oxygène résiduel de l'atmosphère présente au-dessus du circuit, dans le but de réduire, quand cela est jugé nécessaire, à un minimum ce niveau d'oxygène résiduel.

Selon un autre aspect de l'invention, durant le temps où le circuit est en regard de la sortie de gaz d'au moins l'un des appareils, le circuit est porté à une température comprise entre la température ambiante et la température de fusion de l'alliage utilisé pour effectuer l'opération de brasage à la vague ultérieure. Cette borne haute dépendra donc de l'alliage utilisé, elle se situera par exemple au voisinage de 180 °C dans le cas des alliages Sn63-Pb37 ou Sn62-Pb36-Ag2 utilisés classiquement. Avantageusement, et selon le cas de chaque type de pièce ou support traité, afin de limiter la croissance d'intermétalliques, on s'efforcera d'adopter une température qui ne soit pas trop proche de la température de fusion de l'alliage utilisé, par exemple ne dépassant pas 160 °C dans le cas des alliages Sn63-Pb37 ou Sn62-Pb36-Ag2.

Selon un des aspects de l'invention, le circuit est amené en regard des sorties de gaz des appareils, par un système de convoyage traversant un espace intérieur délimité par une structure de capotage (par exemple un tunnel ou un ensemble de capotages élémentaires), isolé de l'atmosphère environnante, la structure étant raccordée de façon étanche aux appareils ou incluant les appareils.

Selon une des mises en oeuvre de l'invention, au moins un des appareils, dans lequel est transformé un mélange gazeux initial, est le siège d'une décharge électrique créée entre une première électrode et une seconde électrode, une couche d'un matériau diélectrique étant disposée sur la surface d'au moins une des électrodes, en regard de l'autre électrode, le mélange gazeux initial transformé dans cet appareil traversant la décharge transversalement aux électrodes.

L'énergie mise en oeuvre dans l'appareil, ramenée à l'unité de surface de diélectrique sera alors avantageusement supérieure ou égale à un 1W/cm², préférentiellement supérieure ou égale à 10W/cm², le plus souvent comprise dans l'intervalle [10 W/cm², 100 W/cm²].

Selon une des mises en oeuvre de l'invention, le mélange gazeux initial transformé dans au moins l'un des appareils comprend de la vapeur d'eau, la teneur en vapeur d'eau du mélange gazeux initial considéré qui comprend de la vapeur d'eau est alors avantageusement comprise dans la gamme [50 ppm, 6 %], préférentiellement dans la gamme [100 ppm, 1 %], mais plus préférentiellement dans la gamme [500 ppm, 5000 ppm].

Selon une autre des mises en oeuvre de l'invention, le mélange gazeux initial transformé dans au moins l'un des appareils comprend de l'oxygène. Dans ce dernier cas, la teneur en oxygène du mélange gazeux initial est avantageusement maintenue inférieure à quelques centaines de ppm.

Selon une autre des mises en oeuvre de l'invention, le mélange gazeux initial transformé dans au moins l'un des appareils consiste en un mélange azote/hydrogène/vapeur d'eau.

Selon une autre des mises en oeuvre de l'invention, le mélange gazeux initial le mélange gazeux initial transformé dans au moins l'un des appareils consiste en un mélange azote/hydrogène/vapeur d'eau/oxygène.

Selon une des mises en oeuvre de l'invention, le mélange gazeux initial transformé dans au moins l'un des appareils comporte de l'hydrogène, sa teneur en hydrogène sera alors avantageusement située dans la gamme [1000 ppm, 50 %], mais préférentiellement inférieure ou égale à 10 %.

Selon une des mises en oeuvre de l'invention, on réalise un zonage de l'atmosphère rencontrée successivement par le circuit le long du convoyeur, de la façon suivante :
a) au moins un des appareils de formation d'espèces gazeuses excitées ou instables, transforme un mélange gazeux initial différent de celui transformé par l'appareil le précédant dans la dite structure, et/ou
b) le mélange gazeux adjacent mis en oeuvre au niveau d'au moins un des appareils de formation d'espèces gazeuses excitées ou instables est différent de celui mis en oeuvre au niveau de l'appareil le précédant dans la dite structure.

Selon une des mises en oeuvre de l'invention, les étapes a) et b) ci-dessus pourront concerner un même appareil.

Selon l'un des aspects de l'invention, en amont ou en aval du groupement d'appareils rencontré par le circuit (donc de l'opération de traitement que ce groupement réalise), le circuit est soumis à une opération de préchauffage. On pourra ainsi par exemple procéder aux successions suivantes d'étapes :
- un traitement (fluxage) selon l'invention (à froid ou à chaud) suivi d'une opération de préchauffage (suivi du brasage);
- une opération de préchauffage suivie d'un traitement selon l'invention (à froid ou à chaud) (suivi du brasage);
- un traitement selon l'invention (à froid), suivi d'une opération de préchauffage, suivie d'un autre traitement selon l'invention (à chaud) (suivi du brasage),

cette liste de successions n'étant bien entendu qu'illustrative des nombreuses possibilités qu'offre l'invention.

En aval de la mise en contact du circuit avec la ou les vagues de soudure, donc en aval de l'opération de brasage proprement dite, on pourra le cas échéant amener au moins une des faces du circuit en regard de la sortie de gaz d'au moins un appareil (que l'on peut qualifier de "aval") de formation d'espèces gazeuses excitées ou instables dans lequel on fait passer un mélange gazeux initial (que l'on peut ici encore qualifier de "aval") comprenant un gaz inerte et/ou un gaz réducteur et/ou un gaz oxydant, pour obtenir en sortie de gaz de l'appareil, un mélange gazeux primaire aval comprenant des espèces excitées ou instables et substantiellement dépourvu d'espèces électriquement chargées, ceci permettant si nécessaire d'effectuer un post nettoyage de la surface du circuit.

On peut également envisager que durant tout ou partie de la mise en contact avec la ou les vagues de soudure, au moins une des faces du circuit soit mise en contact avec la sortie de gaz d'au moins un appareil que l'on peut qualifier de "supplémentaire" de formation d'espèces gazeuses excitées ou instables dans lequel on fait passer un mélange gazeux initial (que l'on peut également qualifier de "supplémentaire") comprenant un gaz inerte et/ou un gaz réducteur et/ou un gaz oxydant, pour obtenir en sortie de gaz de l'appareil, un mélange gazeux primaire "supplémentaire" comprenant des espèces gazeuses excitées ou instables et substantiellement dépourvu d'espèces électriquement chargées.

Comme il apparaîtra clairement à l'homme du métier, ce traitement "supplémentaire", réalisé durant le brasage même, peut apparaître très avantageux en vu notamment d'éliminer substantiellement les oxydes qui pourraient se former au niveau de l'alliage de brasure.

Selon un aspect de l'invention, on prévoit la mise en place d'un régime que l'on peut qualifier de "veille" du traitement réalisé avant brasage, quand l'opération de brasage doit être provisoirement arrêtée.

On pourra ainsi prévoir selon l'invention des situations dans lesquelles, par exemple suite à une action volontariste de l'utilisateur, ou encore du fait qu'aucun circuit n'a été détecté à l'entrée de la structure durant une période de temps qui a été prédéfinie, on déclenche au moins l'une des mesures suivantes :
- on stoppe l'alimentation de chaque appareil en mélange gazeux primaire;
- on maintient dans chaque appareil un débit réduit du mélange gazeux primaire qui circule dans l'appareil considéré (par exemple quelques % ou quelques dizaines de % du débit circulant en régime nominal utilisé pour le traitement);
- quand un mélange gazeux adjacent est mis en oeuvre au niveau d'au moins l'un des appareils, on stoppe l'alimentation en mélange gazeux adjacent au niveau d'au moins l'un de ces appareil;
- on fait passer, dans chaque appareil, en lieu et place du mélange gazeux primaire qui circule dans l'appareil considéré, un mélange gazeux primaire que l'on peut qualifier d'attente (par exemple un gaz neutre ou encore un mélange gaz neutre/hydrogène...);
- on bascule chaque appareil du régime de traitement où il se trouvait à un régime d'attente où la densité d'énergie qui y est mise en oeuvre n'est que de quelques W/cm².

L'invention concerne aussi un dispositif de brasage à la vague de circuits à l'aide d'un alliage liquide, comprenant:
- une structure de capotage, définissant un espace intérieur traversé par des moyens de convoyage des circuits, isolé de l'atmosphère environnante, définissant un parcours de convoyage des circuits à l'intérieur de la structure,
- au moins deux appareils de formation d'espèces gazeuses excitées ou instables montés en série, comprenant au moins un passage de gaz tubulaire ayant un axe, formé entre une électrode extérieure et une électrode intérieure, l'une au moins des électrodes comportant, en regard de l'autre, un revêtement diélectrique, les électrodes étant reliées à une source haute tension et haute fréquence, l'électrode extérieure entourant le diélectrique et comportant au moins une entrée de gaz dit initial et au moins une sortie de gaz dit primaire allongées , parallèles à l'axe et sensiblement diamétralement opposées, ladite sortie de gaz débouchant à l'intérieur de la structure, la structure entourant ou se raccordant de façon étanche aux appareils,
   au moins un des appareils se situant au dessus du parcours, au moins un autre des appareil se situant au dessous du parcours, et
- un bac apte à contenir un bain de l'alliage, situé en aval de la structure (donc hors structure) ou bien en aval des appareils, la structure entourant alors ou se raccordant de façon étanche au bac.

Selon une des mises en oeuvre de l'invention, la structure est munie d'au moins un moyen d'injection d'un gaz dit adjacent ne transitant pas par au moins l'un des appareils.

Selon un aspect de l'invention, le dispositif comporte, en amont ou en aval des appareils, des moyens de chauffage des circuits.

D'autres caractéristiques et avantages de la présente invention ressortiront de la description suivante de modes de réalisation donnée à titre illustratif mais nullement limitatif, faite en relation avec les dessins annexés, sur lesquels :
- la figure 1 est une vue schématique d'une structure de capotage selon l'invention se raccordant à trois appareil de formation d'espèces gazeuses excitées ou instables, convenant pour la mise en oeuvre du procédé selon l'invention.
- la figure 2 représente schématiquement en coupe un exemple d'appareil de formation d'espèces gazeuses excitées ou instables convenant pour la mise en oeuvre du procédé selon l'invention.
- la figure 3 est une représentation schématique d'un dispositif (machine) de brasage à la vague convenant pour la mise en oeuvre de l'invention.

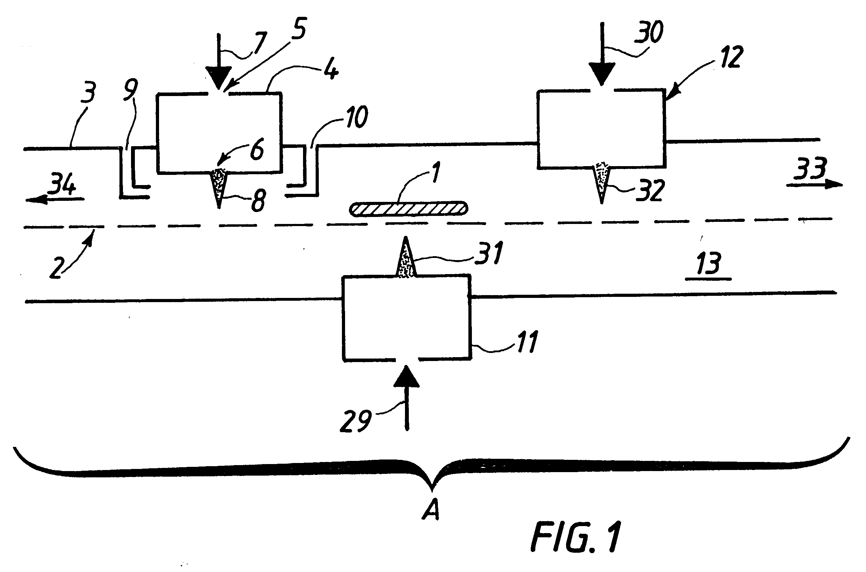

On reconnaît sur la figure 1, la présence d'un circuit 1 à braser (représenté par une simple épaisseur, les composants électroniques non pas été représentés sur cette figure), amené grâce à un système de convoyage non représenté pour des raisons de clarté (par exemple du type comportant deux chaînes de doigts agrippant le circuit de part et d'autre du tunnel), le long d'un parcours de convoyage 2, en regard des sorties de gaz de trois appareils de formation d'espèces gazeuses excitées ou instables 4, 12, 11. On a référencé 6 la sortie de gaz du premier appareil.

Le parcours de convoyage 2 traverse un espace intérieur 13, délimité par une structure de capotage (ici un tunnel) 3, raccordé avantageusement de façon étanche aux appareils.

On a schématisé en 8, 31, 32 les mélanges gazeux primaires obtenus en sorties de gaz des appareils et rencontrés successivement par le circuit, obtenus par transformation dans chaque appareil respectivement des mélanges initiaux 7, 29 et 30.

On a référencé 5 l'entrée de gaz de l'appareil 4.

On note aussi sur le mode de réalisation représenté sur la figure 1 la présence d'entrées de mélanges gazeux adjacents 9, 10 au niveau de l'appareil 4.

L'installation est par ailleurs pourvue, le cas échéant, d'un moyen de chauffage du circuit 1, non représenté sur la figure 1. On pourra par exemple envisager, pour ce moyen de chauffage, des lampes infra-rouge présentes dans le tunnel, ou un chauffage par convection (parois chaudes du tunnel) ou encore le fait que la pièce soit posée sur un porte-substrat chauffant.

La structure de la figure 1 a été représentée indépendamment de toute machine de brasage à la vague mais comme largement développé plus haut, on peut envisager de nombreux agencements possibles de cette structure :
- le fait par exemple qu'en sortie de cette structure de tunnel 3, le circuit entre dans une machine de brasage à la vague (direction référencée 33), le circuit étant, entre la sortie du tunnel et l'entrée de la machine le cas échéant maintenu sous atmosphère protectrice;
- ou encore le fait que traitement selon l'invention et opération de brasage sont réalisés au sein de la même structure de tunnel 3 (le bac de soudure étant alors situé en aval du dernier appareil rencontré, ici 12). On a alors symbolisé par la référence 34 la direction de l'entrée de la structure et par la référence 33 la direction de localisation du bain de soudure.

Comme détaillé précédemment, l'ensemble A constitué de la portion de tunnel incorporant les trois appareils de formation d'espèces gazeuses excitées ou instables 4, 12, 11 sera alors nécessairement situé en amont du bain de soudure, mais pourra être situé selon les cas en amont ou en aval d'une étape de préchauffage des circuits.

Comme il apparaîtra clairement à l'homme du métier, si la figure 1 illustre une configuration particulière de positionnement respectif des appareils, toutes les configurations d'espacement entre les appareils peuvent être envisagées selon l'invention, y compris le fait que deux appareils se trouvent l'un au dessus de l'autre.

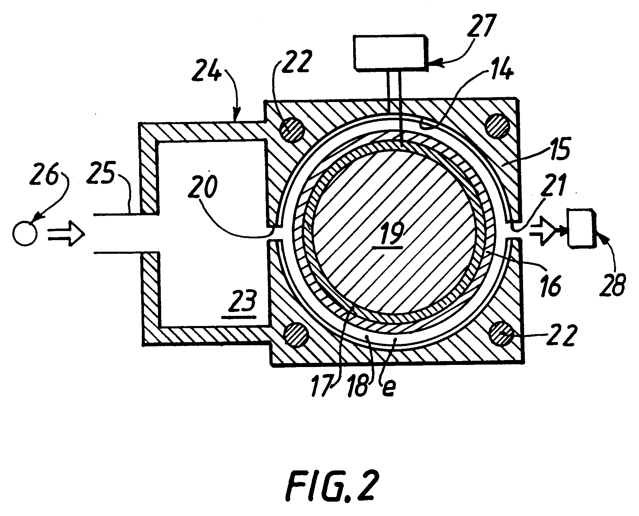

Comme représenté sur le mode de réalisation de la figure 2, l'appareil pour ce mode de réalisation est de géométrie cylindrique, il comprend une première électrode tubulaire 14, formée par exemple par une face interne d'un bloc métallique 15, et dans laquelle est disposé concentriquement un ensemble d'un tube en matériau diélectrique 16, par exemple en céramique, sur la face interne duquel est déposée, par métallisation, une deuxième électrode 17, exagérément épaissie sur la figure 2 pour une meilleure compréhension.

L'ensemble du diélectrique 16 et de la deuxième électrode 17 défini ainsi, avec la première électrode 14, un passage tubulaire de gaz 18, et, intérieurement, un volume interne 19 dans lequel on fait circuler un réfrigérant, avantageusement un Fréon pour son caractère électronégatif ou encore de l'eau permutée. Le passage de gaz interne 18 a une extension axiale inférieure à 1 m, typiquement inférieure à 50 cm, et son épaisseur radiale e n'excède pas 3 mm et est typiquement inférieure à 2,5 mm.

Le bloc 15 comporte, diamétralement opposées, deux fentes longitudinales 20 et 21 formant respectivement l'entrée du gaz initial à exciter dans le passage 18 et la sortie du flux de gaz primaire comportant des espèces gazeuses excitées ou instables.

Les fentes 20 et 21 s'étendent sur toute la longueur axiale de la cavité 18 et ont une largeur qui pour le mode de réalisation représenté figure 2, n'excède pas l'épaisseur e et est typiquement sensiblement identique à cette dernière (d'autres configurations pourraient être envisagées telles que par exemple une largeur légèrement supérieure à l'épaisseur e). Le corps 15 comporte avantageusement, à la périphérie de la première électrode 14, une pluralité de conduits 22 pour le passage d'un réfrigérant, par exemple de l'eau. L'entrée de gaz 20 communique avec une chambre ou plénum d'homogénéisation 23 formée dans un boîtier 24 accolé au bloc 15 et comportant une tubulure 25 d'amenée de gaz initial, en provenance d'une source de gaz initial 26, et donc à une pression qui pourra varier selon cette source typiquement de quelques bars à 100 ou 200 bars. Les électrodes 14 et 17 sont reliées à un générateur électrique haute tension et haute fréquence 27, fonctionnant à une fréquence avantageusement supérieure à 15 kHz, délivrant une puissance par exemple de l'ordre de 10 kW. On pourra d'ailleurs avantageusement exprimer cette puissance délivrée par le générateur en la ramenant à la surface de diélectrique.

Le flux gazeux contenant les espèces excitées, disponible à la sortie de gaz 21, est adressé à un poste utilisateur 28, par exemple pour le fluxage de surfaces métalliques.

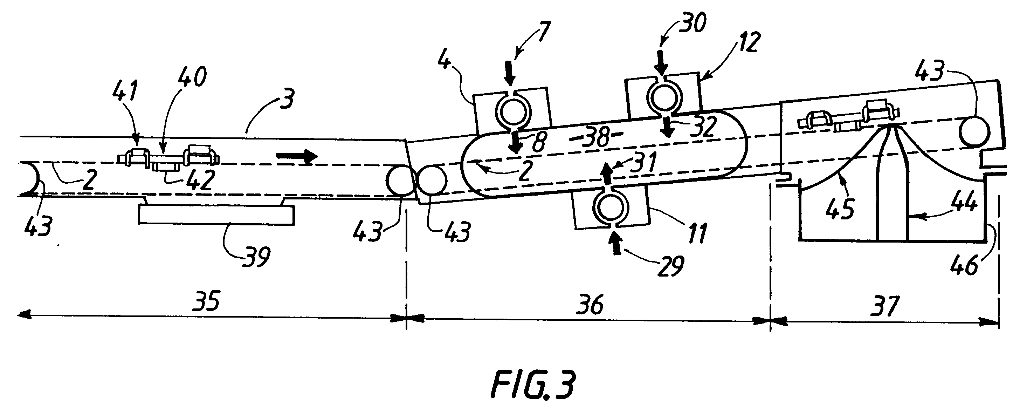

La figure 3 illustre de façon schématique un des modes de réalisation d'une machine de brasage à la vague selon l'invention.

Cette machine peut être divisée en trois zones :
- une zone 35 de préchauffage des circuits (à l'aide de moyens 39 situés dans la partie basse de cette zone),
- une zone 36 de traitement des circuits avant brasage (à l'aide de trois appareils 4 12, 11 les appareils 4 et 12 étant situés en regard de la face supérieure de chaque circuit qui transite dans la machine tandis que l'appareil 11 est situé en regard de sa face inférieure),
- une zone 37 de brasage à la vague (la vague étant formée par pompage d'un bain de soudure contenu dans un bac 46 au travers d'une buse 44).

Le circuit 40 (sur lequel on a reporté des composants électroniques du type inséré à fil 41 comme du type monté en surface 42) passe d'une zone à l'autre de la machine, qui est tunnelée (3) sur toute sa longueur, à l'aide d'un système de convoyage comportant deux chaînes de doigts agrippant le circuit de part et d'autre du tunnel. On a simplement représenté sur la figure le parcours de convoyage 2 des circuits à l'intérieur de la machine, ainsi que les systèmes 43 réalisant le déplacement des chaînes de convoyage.

Entre la zone de préchauffage et la zone de brasage, chaque circuit subi un traitement par sa mise en contact successive avec les mélanges gazeux primaires obtenus aux sorties de gaz des appareils 4 (face supérieure du circuit), puis 11 (face inférieure du circuit) et enfin 12 (à nouveau face supérieure).

Aucune entrée de mélange adjacent dans le tunnel n'a été mentionnée pour ce mode de réalisation.

On a schématisé par la référence 38 l'atmosphère de traitement rencontrée par le circuit dans cette zone.

Un dispositif tel que celui décrit en relation avec la figure 3, intégrant trois appareils tels que celui décrit en relation avec la figure 2, a été utilisé pour la réalisation d'exemples de mise en oeuvre de l'invention.

Les conditions communes de mise en oeuvre de ces exemples sont les suivantes :
- chaque appareil met en oeuvre une puissance de l'ordre de 3 kW, correspondant à une densité de puissance de l'ordre de 35 W/cm²;
- la zone de préchauffage maintient une température au niveau des circuits de l'ordre de 150 à 160°C,
- vitesse de convoyage des circuits dans la zone 36 : 8 cm/min,
- au niveau de chacun des trois appareils, le circuit est chauffé (température des circuits maintenus à un niveau de l'ordre de 150 à 160°C) par la présence en vis à vis de chaque appareil d'un tube radiant (au niveau de chaque appareil, le circuit est donc situé "en sandwich" entre l'appareil et un tube radiant non représenté sur la figure 3),
- les circuits testés étaient du type circuits imprimés (PCB) préétamés, double face à trous métallisés, comportant des composants des deux catégories "montés en surface" et "insérés à fil";
- pour chaque exemple, on a dénombré pour chaque circuit brasé le nombre de défauts de brasure sur les composants à fils, particulièrement délicats à traiter (défaut de remontée de la brasure dans les trous métallisés). Chaque exemple donne alors la moyenne du nombre de défauts observés par carte, pour au moins 10 cartes brasées, et sachant qu'une carte comporte 100 points de brasure du type "trou métallisé".

Pour le premier exemple de mise en oeuvre, les conditions d'opération et les résultats obtenus sont les suivants :
- mélange initial transformé dans le premier et second appareil : 17 m³/h d'un mélange N₂/H₂ à 4 % d'hydrogène;
- mélange initial transformé dans le troisième appareil (12) : 17 m³/h d'un mélange N₂/H₂/H₂O, à 4 % d'hydrogène et 1000 ppm H₂O,
- taux de défauts moyen : < 10 %

Pour le second exemple, comparatif, seul un appareil (11) était utilisé dans la zone 36, en regard de la face inférieure du circuit.

Pour le type de circuit traité, le taux de défauts pour les points particuliers de brasage que constituent les trous métallisés avoisinait les 60%, que le mélange initial traité dans l'unique appareil soit le mélange N₂/H₂/H₂O utilisé dans l'exemple 1 ou un mélange N₂/H₂ à 4 % d'hydrogène.

Les résultats décrits ci-dessus illustrent l'amélioration très sensible des résultats observés sur les points du circuit les plus difficiles à braser (composants à fil, trous métallisés) par l'utilisation d'au moins un appareil en regard de chaque face du circuit, ici en l'occurrence deux appareils en regard de la face supérieure.

Les résultats obtenus à l'aide d'un seul appareil en face supérieure (en plus de l'appareil situé en face inférieure) se sont révélés certes satisfaisants pour le circuit testé, mais nécessitait de réduire la vitesse de passage du circuit sous l'appareil (en comparaison de la vitesse de passage que l'on peut utiliser quand deux appareils sont positionnés en face supérieure). On comprend dès lors qu'il est nécessaire de trouver selon le cas de chaque utilisateur (circuits traités, productivité recherchée..) le meilleur compromis.

Quoique la présente invention ait été décrite en relation avec des modes de réalisation particuliers, elle ne s'en trouve pas limitée pour autant mais est au contraire susceptible de modifications et de variantes qui apparaîtront à l'homme de l'art dans le cadre des revendications ci-après.

## Revendications

1. Procédé de brasage à la vague d'un circuit, au cours duquel, on met en contact le circuit (1) avec au moins une vague (45) d'un alliage de soudure liquide, obtenue par pompage d'un bain liquide de l'alliage, contenu dans un bac (46), au travers d'au moins une buse (44), caractérisé en ce que, au préalable, chacune des faces du circuit a été, à une pression voisine de la pression atmosphérique, amenée en regard de la sortie de gaz d'au moins un appareil (4, 12, 11) de formation d'espèces gazeuses excitées ou instables dans lequel on fait passer un mélange gazeux initial (7, 29, 30) comprenant un gaz inerte et/ou un gaz réducteur et/ou un gaz oxydant, pour obtenir, après transformation dans l'appareil, en sortie de gaz de l'appareil, un mélange gazeux primaire (8, 31, 32)) comprenant des espèces gazeuses excitées ou instables et substantiellement dépourvu d'espèces électriquement chargées.

2. Procédé selon la revendication 1, caractérisé en ce que la face supérieure du circuit est successivement amenée en regard des sorties de gaz d'au moins deux (4, 12) appareils de formation d'espèces gazeuses excitées ou instables disposés en série.

3. Procédé selon l'une des revendications 1 ou 2, caractérisé en ce que le circuit est amené en regard des sorties de gaz des dits appareils par un système de convoyage (43, 2) traversant un espace intérieur (13) délimité par une structure de capotage (3), isolé de l'atmosphère environnante, ladite structure étant raccordée de façon étanche aux dits appareils ou incluant les dits appareil.

4. Procédé selon la revendication 3, caractérisé en ce que le circuit ressort de ladite structure pour entrer dans une machine où est effectuée la dite mise en contact avec la ou les vagues de soudure liquide, la pièce étant, le cas échéant, entre la sortie de ladite structure et l'entrée de la dite machine, maintenue sous atmosphère protectrice.

5. Procédé selon la revendication 3, caractérisé en ce que la dite mise en contact avec la ou les vagues de soudure liquide est réalisée au sein de la même dite structure, en aval desdits appareils.

6. Procédé selon l'une des revendications 1 à 5, caractérisé en ce que durant le temps où le circuit est en regard de la sortie de gaz d'au moins l'un des dits appareils, le circuit est porté à une température comprise entre la température ambiante et la température de fusion du dit alliage.

7. Procédé selon la revendication 6, caractérisé en ce que la température de fusion du dit alliage est voisine de 180 °C, et en ce que la dite température à laquelle est portée le circuit ne dépasse pas 160 °C.

8. Procédé selon l'une des revendications 1 à 7, caractérisé en ce que, en amont ou en aval des dits appareils, le circuit est soumis à une opération de préchauffage.

9. Procédé selon l'une des revendications 1 à 8, caractérisé en ce que le mélange gazeux initial transformé dans au moins l'un des dits appareils comprend de la vapeur d'eau, et en ce que la teneur en vapeur d'eau du mélange gazeux initial considéré qui comprend de la vapeur d'eau est comprise dans la gamme [100 ppm, 1 %], préférentiellement dans la gamme [500 ppm, 5000 ppm].

10. Procédé selon l'une des revendications 1 à 9, caractérisé en ce que le mélange gazeux initial transformé dans au moins l'un des dits appareils comprend de l'oxygène.

11. Procédé selon l'une des revendications 1 à 9, caractérisé en ce que le mélange gazeux initial transformé dans au moins l'un des dits appareils consiste en un mélange azote/hydrogène/vapeur d'eau.

12. Procédé selon la revendication 10, caractérisé en ce que le mélange gazeux initial transformé dans au moins l'un des dits appareils consiste en un mélange azote/hydrogène/vapeur d'eau/oxygène.

13. Procédé selon l'une des revendications 1 à 12, caractérisé en ce que le mélange gazeux initial transformé dans au moins l'un des dits appareils comprend de l'hydrogène et en ce que la teneur en hydrogène du mélange gazeux initial considéré qui comprend de l'hydrogène est située dans la gamme [1000 ppm, 50%], préférentiellement inférieure ou égale à 10 %.

14. Procédé selon l'une des revendications 1 à 13, caractérisé en ce que au moins l'un des dits appareils est le siège d'une décharge électrique créée entre une première électrode (14) et une seconde électrode (17), une couche (16) d'un matériau diélectrique étant disposée sur la surface d'au moins une des électrodes (17), en regard de l'autre électrode, et en ce que le mélange gazeux initial qui est transformé dans cet appareil traverse la décharge transversalement aux électrodes.

15. Procédé selon la revendication 14, caractérisé en ce que l'énergie mise en oeuvre dans le dit appareil, ramenée à l'unité de surface de diélectrique est supérieure ou égale à 1W/cm², préférentiellement supérieure ou égale à 10W/cm².

16. Procédé selon l'une des revendications 3 à 5, caractérisé en ce que au moins un des appareils (11, 4, 12) de formation d'espèces gazeuses excitées ou instables transforme un mélange gazeux initial (7) différent de celui transformé par l'appareil le précédant dans ladite structure (3).

17. Procédé selon l'une des revendications 1 à 16, caractérisé en ce que au niveau d'au moins l'un des dits appareils, le circuit est mis en contact avec une atmosphère gazeuse de traitement obtenue à partir du mélange gazeux primaire issu de la sortie de gaz de l'appareil considéré et d'un mélange gazeux adjacent (9,10) qui n'a pas transité par cet appareil.

18. Procédé selon la revendication 17, caractérisé en ce que le mélange adjacent contient du silane SiH₄.

19. Procédé selon la revendication 17 ou 18, caractérisé en ce que l'on réalise un zonage de l'atmosphère rencontrée successivement par le circuit le long du convoyeur, de la façon suivante :
a) au moins un des appareils (11, 4, 12) de formation d'espèces gazeuses excitées ou instables transforme un mélange gazeux initial (7) différent de celui transformé par l'appareil le précédant dans ladite structure (3), et/ou
b) le mélange gazeux adjacent (9, 10) mis en oeuvre au niveau d'au moins un des appareils de formation d'espèces gazeuses excitées ou instables est différent de celui mis en oeuvre au niveau de l'appareil le précédant dans ladite structure (3).

20. Procédé selon la revendication 19, caractérisé en ce que les étapes a) et b) ont lieu au niveau d'un même appareil.

21. Procédé selon l'une des revendications 1 à 20, caractérisé en ce que en aval de la dite mise en contact avec la ou les vagues de soudure, au moins une des faces du circuit est amenée en regard de la sortie de gaz d'au moins un appareil aval de formation d'espèces gazeuses excitées ou instables dans lequel on fait passer un mélange gazeux initial aval comprenant un gaz inerte et/ou un gaz réducteur et/ou un gaz oxydant, pour obtenir en sortie de gaz de l'appareil, un mélange gazeux primaire aval comprenant des espèces gazeuses excitées ou instables et substantiellement dépourvu d'espèces électriquement chargées.

22. Procédé selon l'une des revendications 1 à 21, caractérisé en ce que durant tout ou partie de la dite mise en contact avec la ou les vagues de soudure, au moins une des faces du circuit est en contact avec la sortie de gaz d'au moins un appareil supplémentaire de formation d'espèces gazeuses excitées ou instables dans lequel on fait passer un mélange gazeux initial supplémentaire comprenant un gaz inerte et/ou un gaz réducteur et/ou un gaz oxydant, pour obtenir en sortie de gaz de l'appareil, un mélange gazeux primaire supplémentaire comprenant des espèces gazeuses excitées ou instables et substantiellement dépourvu d'espèces électriquement chargées.

23. Procédé selon l'une des revendications 3 à 22, caractérisé en ce que l'on met en place, en amont ou bien à l'entrée de la dite structure, des moyens de détection de l'arrivée du circuit à l'entrée de la dite structure, et en ce que suite à une action volontariste de l'utilisateur ou du fait qu'aucun circuit n'a été détecté à l'entrée de la dite structure durant une période de temps prédéfinie, on déclenche au moins l'une des mesures suivantes :
- on stoppe l'alimentation de chacun des dits appareils en mélange gazeux primaire;
- on maintient dans chaque appareil un débit réduit du mélange gazeux primaire qui circule dans l'appareil considéré;
- on fait passer, dans chaque appareil, en lieu et place du mélange gazeux primaire qui circule dans l'appareil considéré, un mélange gazeux primaire d'attente.

24. Procédé selon l'une des revendications 17 ou 18, caractérisé en ce que l'on met en place, en amont ou bien à l'entrée de la dite structure, des moyens de détection de l'arrivée du circuit à l'entrée de la dite structure, et en ce que, suite à une action volontariste de l'utilisateur ou du fait qu'aucun circuit n'a été détecté à l'entrée de la dite structure durant une période de temps prédéfinie, on stoppe l'alimentation en mélange gazeux adjacent mis en oeuvre au niveau d'au moins l'un des dits appareils.

25. Procédé selon l'une des revendications 14 ou 15, caractérisé en ce que l'on met en place, en amont ou bien à l'entrée de la dite structure, des moyens de détection de l'arrivée du circuit à l'entrée de la dite structure, et en ce que, suite à une action volontariste de l'utilisateur ou du fait qu'aucun circuit n'a été détecté à l'entrée de la dite structure durant une période de temps prédéfinie, on met chaque appareil en régime d'attente où la densité d'énergie qui y est mise en oeuvre n'est que de quelques W/cm².

26. Dispositif de brasage à la vague de circuits à l'aide d'un alliage liquide, comprenant :
- une structure de capotage (3), définissant un espace intérieur (13) traversé par des moyens de convoyage des circuits, isolé de l'atmosphère environnante, définissant un parcours (2) de convoyage des circuits à l'intérieur de la structure,
- un bac (46) apte à contenir un bain du dit alliage, caractérisé en ce que:
- ledit dispositif comprend ègalement au moins deux appareils (4, 11, 12) de formation d'espèces gazeuses excitées ou instables montés en série, comprenant au moins un passage de gaz tubulaire (18) ayant un axe, formé entre une électrode extérieure (14) et une électrode intérieure (17), l'une au moins des électrodes comportant, en regard de l'autre, un revêtement diélectrique (16), les électrodes étant reliées à une source haute tension et haute fréquence, l'électrode extérieure (14) entourant le diélectrique (16) et comportant au moins une entrée (20) de gaz dit initial et au moins une sortie (21) de gaz dit primaire allongées , parallèles à l'axe et sensiblement diamétralement opposées, ladite sortie de gaz débouchant à l'intérieur de la dite structure, au moins un (4) desdits appareils se situant au dessus dudit parcours, au moins un autre (11) des dits appareil se situant au dessous dudit parcours, la dite structure entourant ou se raccordant de façon étanche aux appareils, et en ce que
- ledit bac (46) est situé en aval de la dite structure, ou bien situé en aval des dits appareils, ladite structure entourant alors ou se raccordant alors de façon étanche au bac.

27. Dispositif selon la revendication 26, caractérisé en ce que la dite structure est munie d'au moins un moyen d'injection (9, 10) d'un gaz dit adjacent ne transitant pas par au moins l'un des dits appareils.

28. Dispositif selon l'une des revendications 26 ou 27, caractérisé en ce qu'il comporte, en amont ou en aval des dits appareils, des moyens de chauffage des circuits.

## Claims

1. Method for wave soldering a circuit, during which the circuit (1) is brought into contact with at least one wave (45) of a liquid soldering alloy, this wave being obtained by pumping a liquid bath of the alloy contained in a vat (46), through at least one nozzle (44), characterized in that each of the faces of the circuit has previously been brought, at a pressure close to atmospheric pressure, in front of the gas outlet of at least one apparatus (4, 12, 11) for forming excited or unstable gas species, through which an initial gas mixture (7, 29, 30) comprising an inert gas and/or a reducing gas and/or an oxidizing gas is passed, in order to obtain, after conversion in the apparatus and at the gas outlet of the apparatus, a primary gas mixture (8, 31, 32) comprising excited or unstable gas species and substantially free of electrically charged species.

2. Method according to Claim 1, characterized in that the upper face of the circuit is successively brought in front of the gas outlets of at least two apparatuses (4, 12) for forming excited or unstable gas species, arranged in series.

3. Method according to either of Claims 1 and 2, characterized in that the circuit is brought in front of the gas outlets of the said apparatuses by a conveyor system (43, 2) passing through an internal space (13) which is bounded by a covering structure (3) and is isolated from the surrounding atmosphere, the said structure being connected in a leaktight manner to the said apparatuses or including the said apparatuses.

4. Method according to Claim 3, characterized in that the circuit emerges from the said structure and enters a machine in which the said contact with the liquid solder wave or waves takes place, the article being kept, if appropriate, under a protective atmosphere between the exit of the said structure and the entry of the said machine.

5. Method according to Claim 3, characterized in that the said contact with the liquid solder wave or waves is carried out within the same said structure, downstream of the said apparatuses.

6. Method according to one of Claims 1 to 5, characterized in that, during the time in which the circuit is in front of the gas outlet of at least one of the said apparatuses, the circuit is heated to a temperature of between ambient temperature and the melting temperature of the said alloy.

7. Method according to Claim 6, characterized in that the melting temperature of the said alloy is close to 180°C, and in that the said temperature to which the circuit is heated does not exceed 160°C.

8. Method according to one of Claims 1 to 7, characterized in that, upstream or downstream of the said apparatuses, the circuit is subjected to a preheating operation.

9. Method according to one of Claims 1 to 8, characterized in that the initial gas mixture converted in at least one of the said apparatuses comprises water vapour, and in that the water vapour content of the initial gas mixture in question, which comprises water vapour, lies in the range [100 ppm, 1 %], preferably in the range [500 ppm, 5000 ppm].

10. Method according to one of Claims 1 to 9, characterized in that the initial gas mixture converted in at least one of the said apparatuses comprises oxygen.

11. Method according to one of Claims 1 to 9, characterized in that the initial gas mixture converted in at least one of the said apparatuses consists of a nitrogen/hydrogen/water vapour mixture.

12. Method according to Claim 10, characterized in that the initial gas mixture converted in at least one of the said apparatuses consists of a nitrogen/hydrogen/water vapour/oxygen mixture.

13. Method according to one of Claims 1 to 12, characterized in that the initial gas mixture converted in at least one of the said apparatuses comprises hydrogen, and in that the hydrogen content of the initial gas mixture in question, which comprises hydrogen, lies in the range [1000 ppm, 50 %], preferably less than or equal to 10 %.

14. Method according to one of Claims 1 to 13, characterized in that at least one of the said apparatuses is the seat of an electric discharge created between a first electrode (14) and a second electrode (17), a layer (16) of a dielectric material being arranged on the surface of at least one of the electrodes (17), facing the other electrode, and in that the initial gas mixture which is converted in this apparatus passes through the discharge transversely to the electrodes.

15. Method according to Claim 14, characterized in that the power used in the said apparatus, normalized per unit surface area of dielectric, is greater than or equal to 1 W/cm², preferably greater than or equal to 10 W/cm².

16. Method according to one of Claims 3 to 5, characterized in that at least one of the apparatuses (11, 4, 12) for forming excited or unstable gas species converts a different initial gas mixture (7) from that converted by the apparatus preceding it in the said structure (3).

17. Method according to one of Claims 1 to 16, characterized in that, at at least one of the said apparatuses, the circuit is brought into contact with a gaseous treatment atmosphere obtained from the primary gas mixture output by the gas outlet of the apparatus in question and from an adjacent gas mixture (9, 10) which has not passed through this apparatus.

18. Method according to Claim 17, characterized in that the adjacent mixture contains silane SiH₄.

19. Method according to Claim 17 or 18, characterized in that the atmosphere successively encountered by the circuit along the conveyor is zoned in the following manner:
a) at least one of the apparatuses (11, 4, 12) for forming excited or unstable gas species converts a different initial gas mixture (7) from that converted by the apparatus preceding it in the structure (3), and/or
b) the adjacent gas mixture (9, 10) employed in at least one of the apparatuses for forming excited or unstable gas species is different from that employed in the apparatus preceding it in the said structure (3).

20. Method according to Claim 19, characterized in that steps a) and b) take place within one and the same apparatus.

21. Method according to one of Claims 1 to 20, characterized in that, downstream of the said contact with the solder wave or waves, at least one of the faces of the circuit is brought in front of the gas outlet of at least one downstream apparatus for forming excited or unstable gas species, through which a downstream initial gas mixture comprising an inert gas and/or a reducing gas and/or an oxidizing gas is passed, in order to obtain, at the gas outlet of the apparatus, a downstream primary gas mixture comprising excited or unstable gas species and substantially free of electrically charged species.

22. Method according to one of Claims 1 to 21, characterized in that, during all or part of the said contact with the solder wave or waves, at least one of the faces of the circuit is in contact with the gas outlet of at least one additional apparatus for forming excited or unstable gas species, through which an additional initial gas mixture comprising an inert gas and/or a reducing gas and/or an oxidizing gas is passed, in order to obtain, at the gas outlet of the apparatus, an additional primary gas mixture comprising excited or unstable gas species and substantially free of electrically charged species.

23. Method according to one of Claims 3 to 22, characterized in that means for detecting the arrival of the circuit at the entry of the said structure are fitted upstream of or else at the entry of the said structure, and in that, as a result of an intentional action by the user or because no circuit has been detected at the entry of the said structure during a predefined time period, at least one of the following measures is initiated:
- the supply of primary gas mixture to each of the said apparatuses is stopped;
- a reduced flow rate of the primary gas mixture which circulates in the apparatus in question is maintained in each apparatus;
- instead of the primary gas mixture which circulates in the apparatus in question, a standby primary gas mixture is passed through each apparatus.

24. Method according to one of Claims 17 or 18, characterized in that means for detecting the arrival of the circuit at the entry of the said structure are fitted upstream of or else at the entry of the said structure, and in that, as a result of an intentional action by the user or because no circuit has been detected at the entry of the said structure during a predefined time period, the supply of adjacent gas mixture used in at least one of the said apparatuses is stopped.

25. Method according to one of Claims 14 and 15, characterized in that means for detecting the arrival of the circuit at the entry of the said structure are fitted upstream of or else at the entry of the said structure, and in that, as a result of an intentional action by the user or because no circuit has been detected at the entry of the said structure during a predefined time period, each apparatus is placed in a standby regime in which the power density used therein is only a few W/cm².

26. Device for wave soldering circuits using a liquid alloy, comprising:
- a covering structure (3) bounding an internal space (13) through which means for conveying the circuits pass, which is isolated from the surrounding atmosphere and which defines a path (2) for conveying the circuits inside the structure,
- a vat (46) suitable for containing a bath of the said alloy, characterized in that:
- the said device also comprises at least two apparatuses (4, 11, 12) for forming excited or unstable gas species, mounted in series, comprising at least one tubular gas passage (18) which has an axis and is formed between an outer electrode (14) and an inner electrode (17), at least one of the electrodes having, facing the other, a dielectric coating (16), the electrodes being connected to a high-voltage and high-frequency source, the outer electrode (14) surrounding the dielectric (16) and having an inlet (20) for so-called initial gas and at least one outlet (21) for so-called primary gas, which are elongated, parallel to the axis and substantially diametrically opposite, the said gas outlet opening inside the said structure, at least one (4) of the said apparatuses being located above the said path, at least one other (11) of the said apparatuses being located below the said path, the said structure surrounding or being connected in a leaktight manner to the apparatuses, and in that
- the said vat (46) is located downstream of the said structure, or else located downstream of the said apparatuses, in which case the said structure surrounds or is connected in a leaktight manner to the vat.

27. Device according to Claim 26, characterized in that the said structure is equipped with at least one means (9, 10) for injecting a so-called adjacent gas which does not pass through at least one of the said apparatuses.

28. Device according to one of Claims 26 and 27, characterized in that it includes, upstream or downstream of the said apparatuses, means for heating the circuits.

## Patentansprüche

1. Verfahren zum Schwallöten eines Schaltkreises, bei dem der Schaltkreis (1) mit mindestens einem Schwall (45) einer flüssigen Lötmittellegierung in Kontakt gebracht wird, welcher über mindestens eine Düse (44) aus einem in einem Behälter (46) befindlichen flüssigen Legierungsbad gepumpt wird, dadurch gekennzeichnet, daß vorher jede der Seiten des Schaltkreises bei annähernd atmosphärischem Druck vor die Gasaustrittsöffnung von mindestens einem Gerät (4, 12, 11) zur Bildung von erregten oder instabilen Gasarten gebracht wird, durch das ein Ausgangsgasgemisch (7, 29, 30), das ein Inertgas und/oder ein reduzierendes Gas und/oder ein oxydierende Gas enthält, geleitet wird, um nach der Umwandlung im Gerät an der Gasaustrittsöffnung des Gerätes ein primäres Gasgemisch (8, 31, 32) zu erhalten, welches erregte oder instabile Gasarten enthält und im wesentlichen frei von elektrisch geladenen Gasen ist.

2. Verfahren nach Anspruch 1, dadurch gekennzeichnet, daß die Oberseite des Schaltkreises nacheinander vor die Gasaustrittsöffnung von mindestens zwei (4, 12) Geräten zur Bildung von erregten oder instabilen Gasarten gebracht wird, wobei diese Geräte in Reihe angeordnet sind.

3. Verfahren nach Anspruch 1 oder 2, dadurch gekennzeichnet, daß der Schaltkreis durch ein Transportsystem (43, 2) vor die Gasaustrittsöffnungen der genannten Geräte geführt wird, wobei dieses System einen Innenraum (13) durchläuft, der durch einen Gehäuseaufbau (3) begrenzt und von der umgebenden Atmosphäre isoliert ist, wobei der genannte Aufbau mit den Geräten dicht verbunden ist oder die genannten Geräte einschließt.

4. Verfahren nach Anspruch 3, dadurch gekennzeichnet, daß der Schaltkreis aus dem Aufbau herausgeführt wird und in eine Maschine einläuft, wo der genannte Kontakt mit dem Schwall oder den Schwällen des flüssigen Lötmittels stattfindet, wobei das Teil zwischen dem Ausgang aus dem genannten Aufbau und dem Eingang in die genannte Maschine gegebenenenfalls unter Schutzatmosphäre gehalten wird.

5. Verfahren nach Anspruch 3, dadurch gekennzeichnet, daß der Kontakt mit dem Schwall oder den Schwällen flüssigen Lötmittels innerhalb desselben Aufbaus und zwar nach den genannten Geräten erfolgt.

6. Verfahren nach einem der Ansprüche 1 bis 5, dadurch gekennzeichnet, daß in der Zeit, wo sich der Schaltkreis gegenüber der Gasaustrittsöffnung von mindestens einem der genannten Geräte befindet, der Schaltkreis auf eine Temperatur gebracht wird, die zwischen der Umgebungstemperatur und der Schmelztemperatur der genannten Legierung liegt.

7. Verfahren nach Anspruch 6, dadurch gekennzeichnet, daß die Schmelztemperatur der genannten Legierung bei ca. 180°C liegt und daß die genannte Temperatur, auf die der Schaltkreis gebracht wird, den Wert von 160°C nicht überschreitet.

8. Verfahren nach einem der Ansprüche 1 bis 7, dadurch gekennzeichnet, daß der Schaltkreis vor oder nach den genannten Geräten einer Vorwarmung unterzogen wird.

9. Verfahren nach einem der Ansprüche 1 bis 8, dadurch gekennzeichnet, daß das Ausgangsgasgemisch, welches in mindestens einem der genannten Geräte umgewandelt wird, Wasserdampf enthält, und daß der Wasserdampfgehalt des betrachteten Ausgangsgasgemisches, welches Wasserdampf enthält, im Bereich von [100 ppm und 1%] und vorzugsweise im Bereich von [500 ppm und 5000 ppm) liegt.

10. Verfahren nach einem der Ansprüche 1 bis 9, dadurch gekennzeichnet, daß das Ausgangsgasgemisch, das in mindestens einem der Geräte umgewandelt wird, Sauerstoff enthält.

11. Verfahren nach einem der Ansprüche 1 bis 9, dadurch gekennzeichnet, daß das Ausgangsgasgemisch, das in mindestens einem der genannten Geräte umgewandelt wird, aus einem Gemisch aus Stickstoff, Wasserstoff und Wasserdampf besteht.

12. Verfahren nach Anspruch 10, dadurch gekennzeichnet, daß das Ausgangsgasgemisch, das in mindestens einem der genannten Geräte umgewandelt wird, aus einem Gemisch aus Stickstoff, Wasserstoff, Wasserdampf und Sauerstoff besteht.

13. Verfahren nach einem der Ansprüche 1 bis 12, dadurch gekennzeichnet, daß das Ausgangsgasgemisch, das in mindestens einem der genannten Geräte umgewandelt wird, Wasserstoff enthält, und daß der Wasserstoffgehalt des betrachteten Ausgangsgasgemischs, welches Wasserstoff enthält, im Bereich von [1000 ppm und 50%), vorzugsweise bei 10% oder darunter, liegt.

14. Verfahren nach einem der Ansprüche 1 bis 13, dadurch gekennzeichnet, daß in mindestens einem der genannten Geräte eine elektrische Entladung stattfindet, die zwischen einer ersten Elektrode (14) und einer zweiten Elektrode (17) generiert wird, wobei auf der Oberfläche von mindestens einer der Elektroden (17) auf ihrer der anderen Elektrode zugewandten Seite eine Schicht (16) eines dielektrischen Materials aufgebracht ist, und wobei das Ausgangsgasgemisch, das in diesem Gerät umgewandelt wird, die Entladung quer zu den Elektroden durchläuft.

15. Verfahren nach Anspruch 14, dadurch gekennzeichnet, daß die im genannten Gerät eingesetzte Energie, die auf die Einheit mit der dielektrischen Oberfläche zurückgeführt wird, größer oder gleich 1W/cm² ist und vorzugsweise größer oder gleich 10W/cm² ist.

16. Verfahren nach einem der Ansprüche 3 bis 5, dadurch gekennzeichnet, daß mindestens eines der Geräte (11, 4, 12) zur Bildung von erregten oder instabilen Gasarten ein Ausgangsgasgemisch (7) umwandelt, das sich von dem Ausgangsgasgemisch, welches durch das im genannten Aufbau (3) vorgeschaltete Gerät umgewandelt wird, unterscheidet.

17. Verfahren nach einem der Ansprüche 1 bis 16, dadurch gekennzeichnet, daß der Schaltkreis bei mindestens einem der genannten Geräte mit einer gasförmigen Behandlungsatmosphäre in Kontakt gebracht wird, welche aus dem primären Gasgemisch, das aus der Gasaustrittsöffnung des betrachteten Geräts entweicht, und aus einem angrenzenden Gasgemisch (9, 10), das dieses Gerät nicht passiert hat, gebildet wird.

18. Verfahren nach Anspruch 17, dadurch gekennzeichnet, daß das angrenzende Gemisch Silan SiH₄ enthält.

19. Verfahren nach Anspruch 17 oder 18, dadurch gekennzeichnet, daß die Atmosphäre, die vom Schaltkreis längs des Transportssystems nacheinander durchlaufen wird, wie folgt in Zonen aufgeteilt wird:
a) mindestens eines der Geräte (11, 4, 12) zur Bildung von erregten oder instabilen Gasarten wandelt ein Ausgangsgasgemisch (7) um, das sich von dem Gasgemisch, das durch das im genannten Aufbau (3) vorgeschaltete Gerät umgewandelt wird, unterscheidet, und/oder
b) das angrenzende Gasgemisch (9, 10), das in mindestens einem der Geräte zur Bildung von erregten oder instabilen Gas eingesetzt wird, unterscheidet sich von dem Gasgemisch, welches in dem im genannten Aufbau (3) vorgeschalteten Gerät eingesetzt wird.

20. Verfahren nach Anspruch 19, dadurch gekennzeichnet, daß die Etappen a) und b) innerhalb ein und desselben Gerätes stattfinden.

21. Verfahren nach einem der Ansprüche 1 bis 20, dadurch gekennzeichnet, daß nach dem genannten Kontakt mit dem Schwall oder den Schwällen von Lötmittel mindestens eine der Seiten des Schaltkreises vor die Gasaustrittsöffnung von mindestens einem nachgeschalteten Gerät zur Bildung von erregten oder instabilen Gasarten geführt wird, wobei durch dieses Gerät ein nachgeschaltetes Ausgangsgasgemisch geleitet wird, welches ein Inertgas und/oder ein reduzierendes Gas und/oder ein oxydierendes Gas enthält, um an der Gasaustrittsöffnung des Gerätes ein nachgeschaltetes primäres Gasgemisch zu erhalten, welches erregte oder instabile Gasarten enthält und weitgehend frei von elektrisch geladenen Arten ist.

22. Verfahren nach einem der Ansprüche 1 bis 21, dadurch gekennzeichnet, daß während der gesamten oder teilweisen Dauer des genannten Kontakts mit dem Lötmittelschwall bzw. den Lötmittelschwällen mindestens eine der Seiten des Schaltkreises mit der Gasaustrittsöffnung von mindestens einem zusätzlichen Gerät zur Bildung von erregten oder instabilen Gasarten in Kontakt ist, durch welches ein zusätzliches Ausgangsgasgemisch geleitet wird, das ein Inertgas und/oder ein reduzierendes Gas und/oder ein oxydierendes Gas enthält, um an der Gasaustrittsöffnung des Gerätes ein zusätzliches primäres Gasgemisch zu erhalten, welches erregte oder instabile Gasarten enthält und weitgehend frei von elektrisch geladenen Arten ist.

23. Verfahren nach einem der Ansprüche 3 bis 22, dadurch gekennzeichnet, daß vor dem oder am Eingang des genannten Aufbaus Mittel zum Erfassen der Ankunft des Schaltkreises am Eingang des genannten Aufbaus angeordnet werden, und daß infolge eines gewollten Eingriffs des Anwenders oder auf Grund dessen, daß innerhalb eines definierten Zeitraums am Eingang des genannten Aufbaus kein Schaltkreis erkannt wurde, mindestens eine der folgenden Maßnahmen ausgelöst wird:
- Die Versorgung jedes der genannten Geräte mit primärem Gasgemisch wird gestoppt;
- In jedem Gerät wird ein geringer Durchsatz des primären Gasgemisches, das in dem betreffenden Gerät zirkuliert, aufrechterhalten;
- Durch jedes Gerät wird anstelle des primären Gasgemischs, das in dem betreffenden Gerät zirkuliert, ein primäres Ersatzgasgemisch geleitet.

24. Verfahren nach Anspruch 17 oder 18, dadurch gekennzeichnet, daß vor dem oder am Eingang des genannten Aufbaus Mittel zum Erfassen der Ankunft des Schaltkreises am Eingang des genannten Aufbaus angeordnet werden, und daß infolge eines gewollten Eingriffs des Anwenders oder auf Grund dessen, daß innerhalb eines definierten Zeitraums am Eingang des genannten Aufbaus kein Schaltkreis erkannt wurde, die Zufuhr des angrenzenden Gasgemischs, das bei mindestens einem der genannten Gerate eingesetzt wird, gestoppt wird.

25. Verfahren nach Anspruch 14 oder 15, dadurch gekennzeichnet, daß vor dem oder am Eingang des genannten Aufbaus Mittel zum Erfassen der Ankunft des Schaltkreises am Eingang des genannten Aufbaus angeordnet werden, und daß infolge eines gewollten Eingriffs des Anwenders oder auf Grund dessen, daß innerhalb eines definierten Zeitraums am Eingang des genannten Aufbaus kein Schaltkreis erkannt wurde, jedes Gerät in einen Bereitschaftszustand versetzt wird, in dem die in diesem Gerät eingesetzte Energiedichte nur wenige W/cm² beträgt.

26. Vorrichtung zum Schwallöten von Schaltkreisen mit Hilfe einer flüssigen Legierung, die folgendes enthält:
- einen Gehäuseaufbau (3), der einen Innenraum (13) definiert, welcher von Mitteln zum Transport von Schaltkreisen durchlaufen wird, von der Umgebungsatmosphäre isoliert ist und im Inneren des Aufbaus eine Transportstrecke (2) für die Schaltkreise definiert,
- einen Behälter (46), der zur Aufnahme eines Bades der genannten Legierung geeignet ist, dadurch gekennzeichnet, daß die genannte Vorrichtung ferner
- mindestens zwei Geräte (4, 11, 12) zur Bildung von erregten oder instabilen Gasarten besitzt, die in Reihe angeordnet sind und mindestens einen rohrförmigen Gasdurchlauf (18) enthalten, welcher eine Achse besitzt und zwischen einer äußeren Elektrode (14) und einer inneren Elektrode (17) gebildet wird, wobei mindestens eine der Elektroden auf ihrer der anderen Elektrode zugewandten Seite eine dielektrische Beschichtung (16) besitzt, und wobei die Elektroden an eine Hochspannungs- und Hochfrequenzquelle angeschlossen sind, wobei die äußere Elektrode (14) die dielektrische Beschichtung (16) umschließt und mindestens einen Eingang (20) für das sogenannte Ausgangsgas und mindestens einen Ausgang (21) für das sogenannte Primärgas besitzt, wobei diese länglich, parallel zur Achse und deutlich diametral zueinander angeordnet sind, wobei der genannte Gasausgang in das Innere des genannten Aufbaus mündet und wobei mindestens eines (4) der genannten Geräte sich über der genannten Transportstrecke befindet und mindestens ein weiteres (11) der genannten Geräte sich unter der genannten Transportstrecke befindet, wobei der genannte Aufbau die Geräte dicht umschließt oder dicht mit den Geräten verbunden ist, und dadurch, daß der genannte Behälter (46) nach dem genannten Aufbau oder nach den genannten Geräten angeordnet ist, wobei der genannte Aufbau den Behälter dicht umschließt oder dicht mit diesem verbunden ist.

27. Vorrichtung nach Anspruch 26, dadurch gekennzeichnet, daß der genannte Aufbau mit mindestens einem Mittel zur Einspritzung (9, 10) eines sogenannten angrenzenden Gases ausgerüstet ist, welches mindestens eines der genannten Geräte nicht durchläuft.

28. Vorrichtung nach Anspruch 26 oder 27, dadurch gekennzeichnet, daß sie vor oder nach den genannten Geräten Mittel zur Erwärmung der Schaltkreise enthält.
